# EUROPEAN PATENT SPECIFICATION

(11) **EP 0 518 578 B1**
(45) Date of publication and mention of the grant of the patent: **25.10.1995**
(21) Application number: 92305206.2
(22) Date of filing: 08.06.1992
(51) Int. Cl.: H01R 9/09, H01R 23/68

(54) **Electric contact unit**
Elektrische Kontaktanordnung
Ensemble de contacts électriques

(30) Priority: 14.06.1991 JP 169384/91
(43) Date of publication of application: 16.12.1992
(73) Proprietor: YAMAICHI ELECTRONICS CO., LTD., Ohta-ku, Tokyo (JP)
(72) Inventor: Matsuoka, Noriyuki, Yokohama-shi, Kanagawa-ken (JP)
(74) Representative: Ben-Nathan, Laurence Albert

(56) References cited:
- EP-A- 0 282 307
- EP-A- 0 341 872
- EP-A- 0 431 566
- US-A- 4 199 209
- US-A- 4 838 806
- US-A- 4 998 886

## Description

### BACKGROUND OF THE INVENTION

This invention relates to an electric contact unit comprising a plurality of electric contacts integrally formed of an insulating material.

As a contact of the type mentioned above, there is known a terminal assembly, as discussed in Japanese Laid-Open (Kokai) Patent Application No. 170177/87, which comprises a plurality of terminals, and insulating sheets interposed between the adjacent terminals, respectively, in several layers. In this prior art, the insulating sheets having elasticity are interposed only between the adjacent electric contacts which are separated from each other. With respect to another prior art, U.S. Patent No. 4,921,430 discloses a connector for an electric part, in which the surface of each electric contact is coated with an insulating film, and the electric contacts are implanted in the upper surface of a connector base formed of an insulating material, with the insulating films intimately attached with respect to each other.

However, the Laid-Open Japanese Patent Application No. 170177/87 has the shortcomings in that since the insulating materials are disposed at only the opposing surfaces of the adjacent electric contacts, an insulation failure is brought about when a foreign matter such as, for example, a metal screw, contacts them. On the other hand, the U.S. Patent No. 4,921,430 has the shortcomings in that since the electric contacts are separated from each other, a considerable amount of labour is required for implanting the electric contacts individually.

Furthermore, in the above Laid-Open Japanese Patent Application No. 170177/87, the electric contacts and the elastic insulating sheets to be inserted between the adjacent electric contacts must be formed in required shapes beforehand, respectively. On the other hand, in the above USP4,921,430, if spaces between the adjacent electric contacts are different from each other, it is required to prepare electric contacts with insulating films having a different thickness for each space.

US-A-4,199,209 illustrates an electrical interconnecting device comprising a plurality of resilient connectors embedded in an elastomeric material with opposing ends thereof being exposed on opposite surfaces of the elastomeric body to provide contact points.

EP-A-0,431,566 illustrates an electric circuit board having interconnect elements embedded in elastomeric material with contact portions exposed at opposite sides of the elastomeric material. The preamble of claim 1 is based on this prior art.

### SUMMARY OF THE INVENTION

It is therefore an object of the present invention to provide an electric contact unit which is capable of effectively coping with the narrow pitches between the adjacent electric contacts in the group of electric contacts in a connector, and which can be assembled onto the base of the connector with ease, and in which a possible short circuit formed between the contacts due to a foreign matter can be prevented effectively, and which enables the contact pieces to be located so as to prevent displacement thereof during an injection molding operation.

The invention provides an electric contact unit in accordance with Claim 1.

According to a feature of the invention, each contact may comprise a laterally extending seat portion from which said contact piece thereof extends, with opposite ends of said seat portion being exposed from respective surfaces of said insulating block.

In some embodiments, an absorption groove may be formed to separate the insulating material portion covering the contact pieces from the remainder of the insulating material of the block.

As mentioned above, since the elastic contact pieces of the electric contacts are integrally molded in an elastic insulating material, with the contact end portions of the electric contacts exposed, the elastic contact pieces being allowed to extend within the integral solid insulating block formed of an insulating material. As a result, even if a foreign matter, such as a metal screw contacts the electric contacts, an insulation failure is not taken place. Furthermore, the electric contact unit can be assembled onto the base of the connector with ease, utilizing the insulating block. In addition, it is no more required to implant the electric contacts individually.

Moreover, by firmly securing the electric contacts into a resin molding metal mold and molding them from an elastic insulating material by means of an injection molding, the insulating block can be formed in a required shape beforehand. Therefore, it is no more required to prepare electric contacts coated with insulating materials having a different thickness for each space between the adjacent electric contacts which are arranged in side by side relation.

Furthermore, metal plating on a portion covered with the insulating block can be saved. Since the electric contacts can be secured at three or more spots thereof to the metal mold, an existing plane for each electric contact is established within the metal mold, and therefore the adjacent pitches between the electric contacts can surely be formed after the injection molding. That is, in the even where the electric contacts are secured at two spots thereof to the metal mold, the electric contacts are rotated about an axis interconnecting the two spots. As a result, in the worst case, the electric contacts are short-circuited within the electric contact unit. However, by virtue of the construction of the present invention, this problem can be solved.

Furthermore, when the electric contact unit is secured to the base of the connector, the press-fit portion required in the prior art for implanting the electric contacts, can be omitted or eliminated, and therefore, the height of the entire unit can be reduced. Moreover, by reducing the distance from the contact end portion of each electric contact to a terminal portion which is to be electrically conducted to a printed circuit board, etc., an inductance component can be reduced in order to cope effectively with high frequency signals.

### BRIEF DESCRIPTION OF THE DRAWINGS

Fig. 1 is a perspective view of an electric contact unit according to one embodiment of the present invention;
Fig. 2 is a side view of the above;
Fig. 3 is a plan view of the above;
Fig. 4 is a front view of the above;
Fig. 5 is a rear view of the above;
Fig. 6 is a front view showing an end portion of a contact now being in pressure-contact with a terminal of an electric part in the above electric contact unit;
Fig. 7 is a side view showing an electric contact unit according to another embodiment of the present invention;
Fig. 8 is a plan view of the above;
Fig. 9 is a front view of the above;
Fig. 10 is a plan view showing the above electric contact unit now assembled onto a base of a connector;
Fig. 11 is a side view of the above;
Fig. 12 is a sectional view taken on line A-A of Fig. 10;
Fig. 13 is likewise a sectional view taken on line B-B of Fig. 10;
Fig. 14 is a plan view showing an electric contact unit according to another embodiment of the present invention, now assembled onto the base of the connector; and
Fig. 15 is a perspective view of the above unit.

### DETAILED DESCRIPTION OF THE EMBODIMENTS

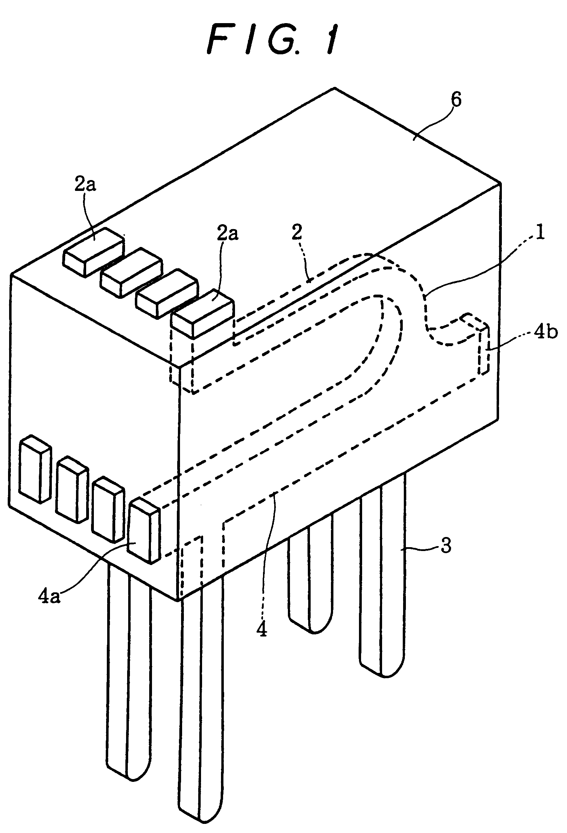

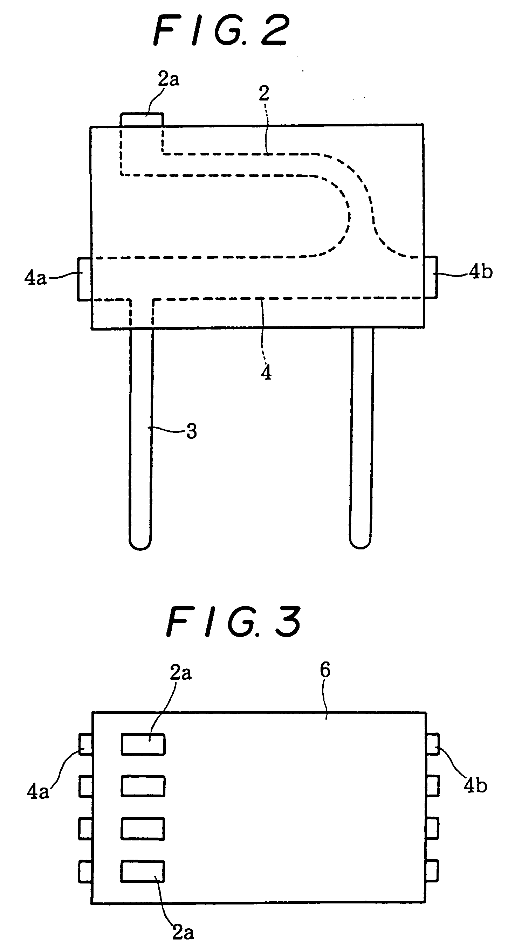

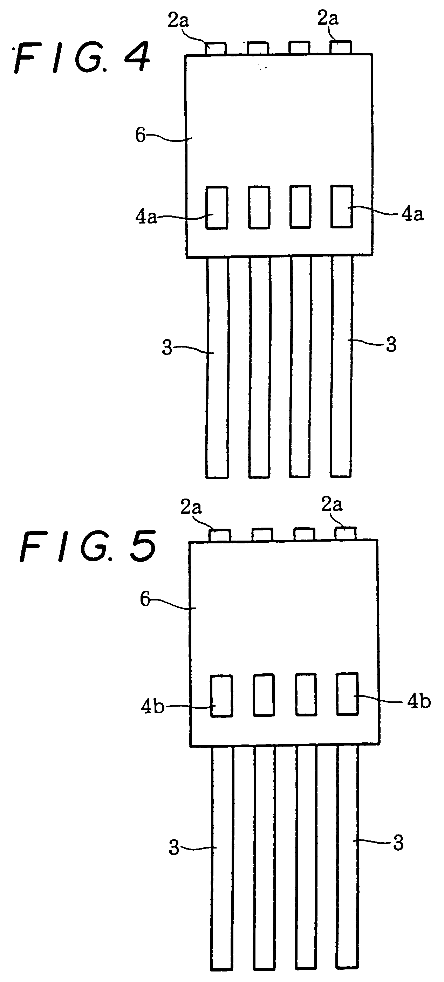

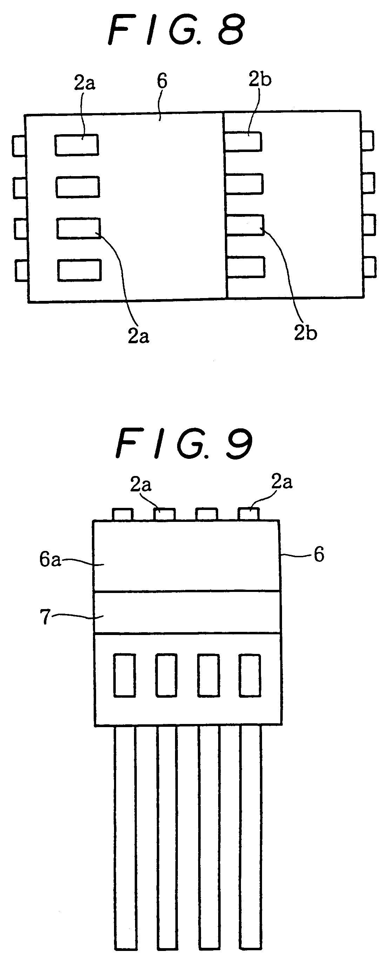

Several embodiments of the present invention will now be described in detail with reference to Figs. 1 to 15 of the accompanying drawing. Each of electric contacts 1 is provided at an upper portion thereof with an elastic contact piece 2, and at a lower portion thereof with a terminal 3. the elastic contact piece 2 and the terminal 3 are connected with each other through a seat piece 4 extending in a lateral direction. These three kinds of component elements 2, 3, and 4 are integrally punched out. The elastic contact piece 2 extends from a rear end side of the seat piece towards a front end side thereof at a location above the seat piece. A contact end portion 2a projecting upward is formed on a distal end of the elastic contact piece 2. By pressing the end portion 2a with a terminal of an electric part such as an IC lead placed thereon, the elastic contact piece 2 is flexed downward. By reaction thereof, the elastic contact piece 2 is brought into contact with the IC lead under pressure.

The terminal 3 is allowed to extend downward from a front end side or rear end side of the seat piece 4 so as to connect to, for example, a wiring board. This terminal 3 may take the forms of a male terminal, a female terminal, etc. in accordance with necessity.

A plurality of electric contacts 1 thus constructed are arranged in side by side relation, and an insulating block 6 is integrally formed of an insulating material having elasticity, so that the group of the electric contacts 1 are formed into one unit through the insulating block 6.

As shown in Figs. 1 to 5, the elastic contact pieces 2 and the seat pieces 4 are allowed to extend within the integral solid insulating block 6, and a relative space between the adjacent electric contacts 1 is maintained between the adjacent blocks 6. Contact end portions 2a of the elastic contact pieces 2 are exposed slightly projecting upwardly from an upper surface of a front end portion of the insulating block 6. The terminals 3 are exposed from a lower surface of the insulating block 6 and allowed to extend downward, so that both a front end 4a and a rear end 4b of the seat piece 4, or one of the front and rear ends are exposed from a front surface and a rear surface of the insulating block 6.

In the above embodiment, at least the contact end portions 2a of the elastic contact pieces 2 are exposed from the surface of the insulating block 6. At this time, the end portions 4a, 4b of the seat pieces 4 are embedded in the insulating material 6, and the terminals 3 may be disposed across the surface of the insulating block 6, or disposed within holes or grooves formed in the surface of the insulating block 6 in accordance with the forms of the terminals 3.

In the above embodiment, each of the elastic contact pieces 2 are exposed at least at three or more end portions including the contact end portion 2a. For molding the group of electric contacts 1, they are placed within a mold, and then a synthetic resin as an insulating material is charged into the mold. At this time, the end portions, for example, the contact end portion 2a and other end portions 4a, 4b, or the contact end portion 2a and other end portions 4a, 3 can be served as means for securing the electric contacts 1 within the mold. By means of three-point support, the existing positions of the electric contacts 1 can be established, so that they would not be pivoted and/or displaced due to charging pressure of the synthetic resin. By virtue of the foregoing arrangement, an electric contact unit according to the present invention can be molded properly.

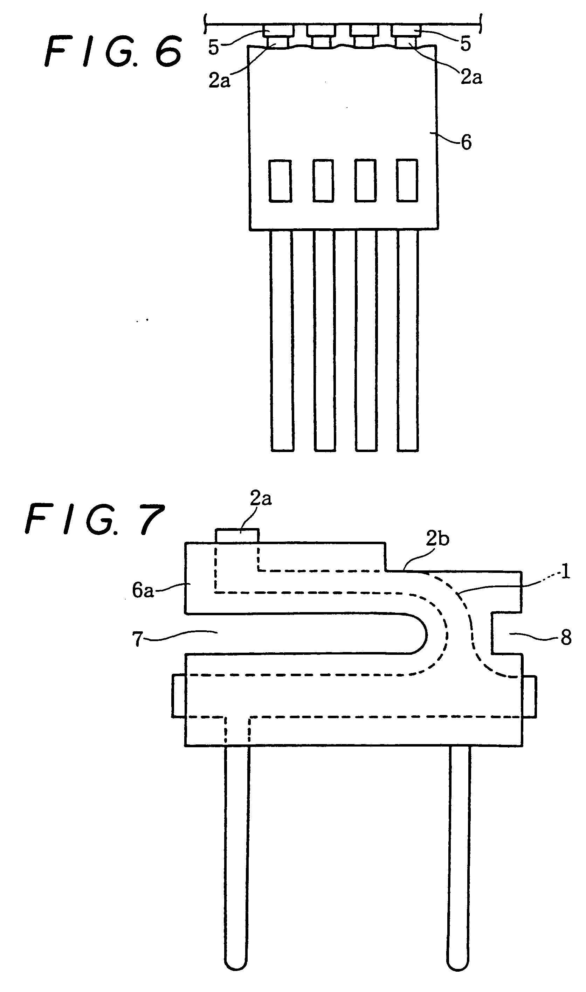

As is shown in Fig. 6, upon depression of the contact end portions 2a, which are exposed from the upper surface of the insulating block 6, with the terminals 5 of an electric part such as IC leads placed thereon, the elastic contact pieces 2 are elastically displaced or shifted downward, while deflecting, under compression, the elastic material which forms the insulating block 6, and a contact pressure with the terminals 5 can be obtained by reactions of the elastic contact pieces 2 and the elastic insulating material.

In Figs. 7 to 9, in order to enhance the elastic displacement of the elastic contact pieces 2 within the insulating block 6, an absorption groove 7 for separating the insulating material portion 6a covering the elastic contact pieces 2 from the remainder is formed in the insulating block 6. More specifically, this absorption groove 7 extends along a lower part of the elastic contact pieces 2. One end of the absorption groove 7 is opened up at the front surface of the insulating block 6, while the other end thereof terminates in position not yet reaching basal portions of the elastic contact pieces 2. Therefore, in this embodiment, the absorption groove 7 extends between the elastic contact pieces 2 and the seat pieces 4.

The insulating block 6 functions as a carrier for carrying the electric contacts 1 and as an auxiliary means for applying a contact pressure. The insulating block 6 also functions as means for assembling the contact unit in a predetermined position of the base of the connector. Figs. 7 to 9 show a representative example, in which a recess 8 or protruded portion is formed at a rear surface and a side surface of the insulating block 6, as an additional construction for assembling the contact unit on the base of the connector.

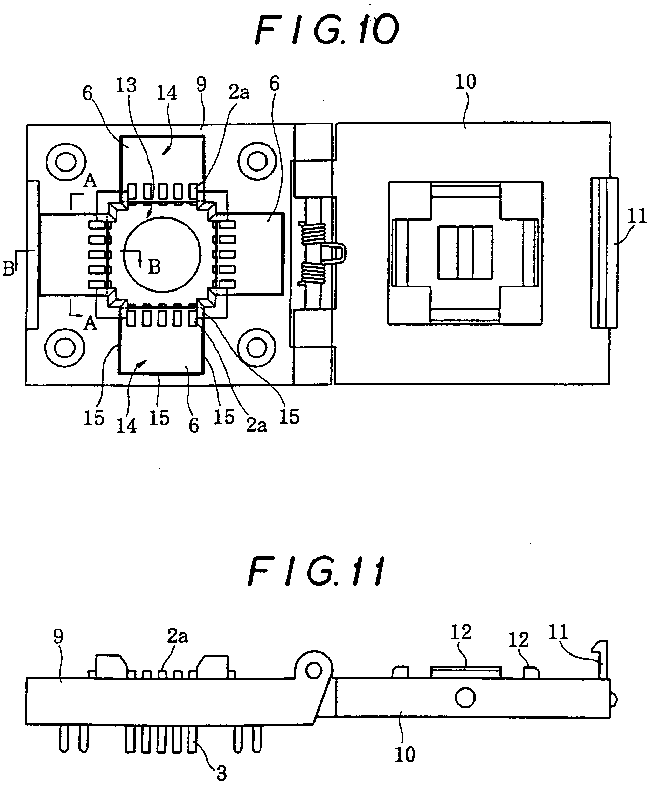

Figs. 10 to 13 show another embodiment, in which the electric contact unit is assembled onto the base 2 of the connector through the insulating block 6. The connector base 9 is provided at a central portion with a space 13 for receiving the electric part. A presser cover 10 is open- and closably, pivotally attached to one end of the connector base 9. The arrangement being such that, when the presser cover 10 is closed onto the base 9, the terminals 5 of the electric part is urged against the corresponding contact end portions 2a. When a lock lever 11 disposed at an end portion of the presser cover 10 is brought into engagement with the end portion of the base 9, the closed condition of the presser cover 10 is maintained, thereby maintaining a contact relation. The numeral 12 denotes a terminal presser pad which is disposed at an inner surface of the cover 10.

The connector base 9 is provided with a receiving space 14 around the receiving space 13, so that the insulating block is engaged therein. For positioning, the insulating block 6 is brought into engagement with the receiving space 14, and the side surfaces, or the front and rear surfaces, or the upper surface of the insulating block 6 is regulated by a regulation wall 15 defining the receiving space 14.

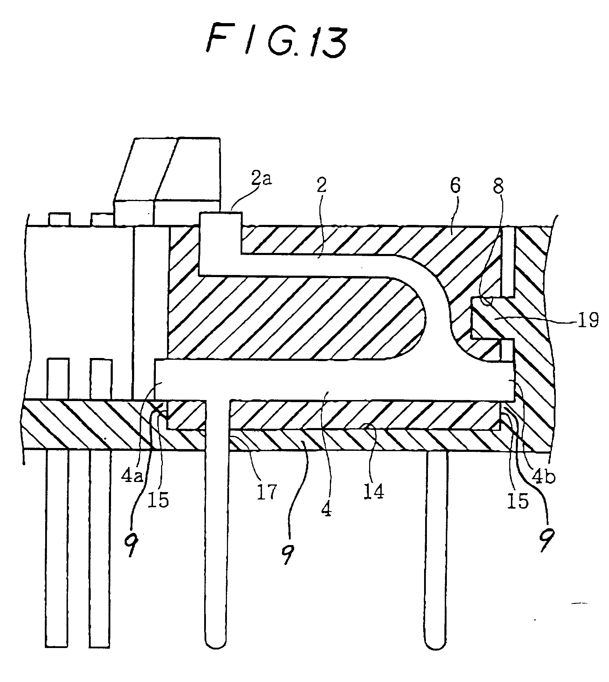

At this time, the recess portion 8 or protruded portion formed at the side surface or rear end face of the insulating block 6 are engaged with a protruded portion or recess portion formed at the regulation wall 15, thus serving as means for retaining the insulating block 6 within the receiving space 14. Fig. 13 shows a modified embodiment, in which a protruded portion 19 is formed on the regulation wall 15 defining the receiving space 14 for receiving the insulating block 6, and this protruded portion 19 is brought into engagement with the recess portion 8 when the insulating block 6 is received in the receiving space 14.

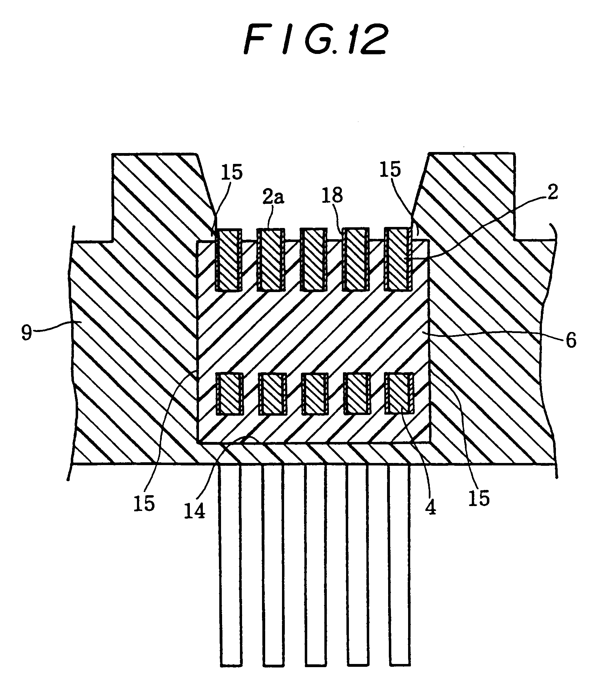

Accompanying the means for engagement using the recess portion 8 and the protruded portion, the insulating block 6 is firmly secured to the inner surfaces of the receiving space by an adhesive agent. Alternatively, the insulating block 6 may be mounted with its corner portions and edge portions intimately or tightly pushed into the receiving space 14, and without using the adhesive agent. In Fig. 12, the insulating block 6 is received within the receiving space 14 with the corner portions and the edge portions of the insulating block 6 pressed by the regulation wall 15.

When the electric contact unit is mounted in the receiving space 14 in the connector base 9, the terminals 3 are inserted into holes 17 formed in the bottom surface of the receiving space 14 and allowed to be projected downward of the connector base 9. Since the electric contact unit can be mounted to the connector base 9 by firmly securing the insulating block 6 into the receiving space 14, the terminals 3 are no more required to be press-fitted into the holes 17. As a result, the terminals 3 are no more required to be provided at basal portions thereof with press-fit claws, in order to be held in the connector base 9. By omitting the press-fit claws as in the prior art, the height of the electric contacts can be reduced, thereby reducing the inductance component between the contact end portions 2a and the terminals 3.

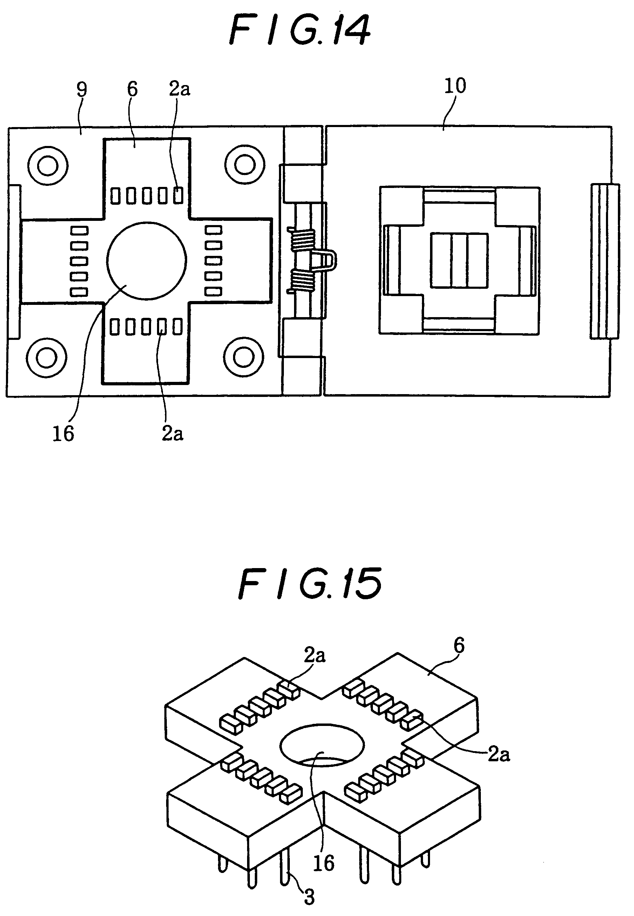

In the above embodiments, a plurality of electric contact units are formed and such plurality of electric contact units are mounted in predetermined positions of the connector base 9. Figs. 14 and 15 show a modified embodiment, in which these unitary insulating blocks are integrally formed. More specifically, the group of electric contacts 1 arranged along two sides or four sides of the electric part receiving space 13 are integrally formed with a common insulating block 6. This insulating block 6 is provided at its central portion with an opening 16 for air passage, corresponding with an opening formed in the receiving space 13, and an electric contact holding block portion of the insulating block 6 is integrally disposed in two ways or four ways about the opening 16.

In the embodiment shown in Figs. 7 to 9, upper surfaces of the elastic contact pieces 2 are exposed from the insulating block 6, on the basal portion side (that is, in positions away from the contact end portions 2a). In this embodiment, a required part of the elastic contact pieces 2 are covered with the insulating block 6, and the remaining part thereof is exposed. Exposed portions 2b of the elastic contact pieces 2 can also be used as means for contacting and measuring a terminal to be tested.

Fig. 12 shows still another embodiment, in which an insulating coating 18 is applied to at least one side surface of the electric contact 1 opposing with a side surface of another electric contact 1, and integrally formed by the insulating block 6. This insulating coating 18 is formed by means of lamination of insulating sheets, coating of an insulating material, or burning. This insulating coating 18 is effective for preventing a formation of short-circuiting between the side surface of the electric contact 1 and a side surface of its adjacent electric contact even if the contacts are warped caused by charging pressure of the resin when the group of electric contacts 1 are inserted into the mold for shaping the insulating block 6.

The present invention also includes a construction in which a plurality of the above mentioned insulating blocks 6 are formed in the longitudinal direction of the elastic contact pieces 2.

As described in the foregoing, according to the present invention, since the elastic contact pieces of the electric contacts are integrally molded in an elastic insulating material, with the contact end portions of the electric contacts exposed, the elastic contact pieces being allowed to extend within the integral solid insulating block formed of an insulating material. As a result, even if a foreign matter, such as a metal screw contacts the electric contacts, a short-circuit can be prevented effectively.

Furthermore, the electric contact unit can be assembled onto the connector base with ease, utilizing the insulating block. In addition, it is no more required to implant the electric contacts individually.

Moreover, by firmly securing the electric contacts into a resin molding metal mold and molding them from an elastic insulating material, the insulating block can easily be formed in a required shape beforehand.

Furthermore, metal plating on a portion covered with the insulating block can be saved. Since the electric contacts can be secured at three or more end portions including the contact end portion to the metal mold, an existing plane for each electric contact is established within the metal mold, and therefore the adjacent pitches between the electric contacts can be obtained.

Furthermore, when the electric contact unit is secured to the connector base, the press-fit portion required in the prior art for implanting the electric contacts, can be omitted, and therefore, the height of the entire unit can be reduced. Moreover, by reducing the distance from the contact end portion of each electric contact to a terminal portion which is to be electrically conducted to a printed circuit board, etc., an inductance component can be reduced in order to cope effectively with high frequency signals.

## Claims

1. An electric contact unit in which a plurality of electric contacts (1) are integrally moulded in an elastic insulating material to form an integral solid insulating block (6) with at least two end portions of the contacts (1) being exposed from a surface of the block (6), characterized in that
said electric contacts (1) have elastic contact pieces (2) which extend within said insulating block (6) and with at least three end portions (2a,3,4a,4b) of each said contacts, including a contact portion (2a) of each said elastic contact pieces (2), being exposed from a surface of said insulating block (6).

2. An electric contact unit according to Claim 1, wherein each contact comprises a laterally extending seat portion (4) from which said resilient contact piece thereof extends.

3. An electric contact unit according to Claim 2, wherein opposite ends (4a,4b) of said seat portion (4) are exposed from respective surfaces of said insulating block (6).

4. An electric contact unit according to Claim 2 or Claim 3, wherein an absorption groove (7) is formed to separate the insulating material portion (6a) covering the contact pieces (2) from the remainder of the insulating material of the block (6).

5. An electric contact unit as claimed in any one of Claims 1 - 3, wherein at least one side surface of each adjacent said electric contact (1) is provided with an insulating coating (18) in addition to said insulating material.

## Patentansprüche

1. Elektrische Kontaktanordnung, bei der mehrere elektrische Kontakte (1) so in einem elastischen Isolationsmaterial geformt sind, daß sie einen einstückigen massiven Isolationsblock (6) bilden, wobei mindestens zwei Endteile der Kontakte (1) von einer Fläche des Blocks (6) freigelegt sind, dadurch gekennzeichnet, daß die elektrischen Kontakte (1) elastische Kontaktstücke (2) haben, die sich in dem Isolationsblock (6) erstrecken und wobei mindestens drei Endteile (2a, 3, 4a, 4b) jedes der Kontakte, einschließlich einem Kontaktteil (2a) jedes der elastischen Kontaktstücke (2), von einer Fläche des Isolationsblocks (6) freigelegt sind.

2. Elektrische Kontaktanordnung nach Anspruch 1, bei der jeder Kontakt einen sich quer erstreckenden Stützteil (4) umfaßt, von dem aus sich dessen Kontaktstück erstreckt.

3. Elektrische Kontaktanordnung nach Anspruch 2, bei der gegenüberliegende Enden (4a, 4b) des Stützteils (4) von jeweiligen Flächen des Isolationsblocks (6) freigelegt sind.

4. Elektrische Kontaktanordnung nach Anspruch 2 oder 3, bei der eine Nut (7) zur Trennung des die Kontaktstücke (2) bedeckenden Isolationsmaterialteils (6a) von dem Rest des Isolationsmaterials des Blocks (6) ausgebildet ist.

5. Elektrische Kontaktanordnung nach einem der Ansprüche 1 - 3, bei der mindestens eine Seitenfläche jedes benachbarten elektrischen Kontaktes (1) zusätzlich zu dem Isolationsmaterial mit einer Isolationsbeschichtung (18) versehen ist.

## Revendications

1. Ensemble de contacts électriques dans lequel une pluralité de contacts électriques (1) sont moulés intégralement dans un matériau isolant élastique pour former un bloc isolant massif intégral (6) avec au moins deux portions d'extrémité des contacts (1) exposées depuis une surface du bloc (6), caractérisé en ce que lesdits contacts électriques (1) ont des pièces de contact élastiques (2) qui s'étendent à l'intérieur dudit bloc isolant (6) et avec au moins trois portions d'extrémité (2a, 3, 4a, 4b) de chacun desdits contacts, incluant une portion de contact (2a) de chacune desdites pièces de contact élastiques (2), étant exposées depuis une surface dudit bloc isolant (6).

2. Ensemble de contacts électriques selon la revendication 1, dans lequel chaque contact comprend une portion de siège (4) s'étendant latéralement, depuis laquelle s'étend ladite pièce de contact élastique.

3. Ensemble de contacts électriques selon la revendication 2, dans lequel des extrémités opposées (4a, 4b) de ladite portion de siège (4) sont exposées depuis des surfaces respectives dudit bloc isolant (6).

4. Ensemble de contacts électriques selon la revendication 2 ou la revendication 3, dans lequel une rainure d'absorption (7) est formée pour séparer la portion de matériau isolant (6a) recouvrant les pièces de contact (2) du reste du matériau isolant du bloc (6).

5. Ensemble de contacts électriques selon l'une quelconque des revendications 1 - 3, dans lequel au moins une surface latérale de chaque dit contact électrique adjacent (1) est pourvue d'un revêtement isolant (18) en plus dudit matériau isolant.
